Europäisches Patentamt

(19) European Patent Office

Office européen des brevets

(11) Veröffentlichungsnummer: **0 075 251**
**B1**

(12) **EUROPÄISCHE PATENTSCHRIFT**

(45) Veröffentlichungstag der Patentschrift:
13.11.85

(51) Int. Cl.⁴: **G 03 B  27/62,** G 03 G  15/26

(21) Anmeldenummer: **82108463.9**

(22) Anmeldetag: **14.09.82**

(54) **Vorlagenhalterung für ein Druckplattenverarbeitungsgerät.**

(30) Priorität: **23.09.81 DE 3137786**

(43) Veröffentlichungstag der Anmeldung:
**30.03.83 Patentblatt 83/13**

(45) Bekanntmachung des Hinweises auf die Patenterteilung:
**13.11.85 Patentblatt 85/46**

(84) Benannte Vertragsstaaten:
**DE FR GB IT NL**

(56) Entgegenhaltungen:
**EP - A - 0 026 016**
**DE - A - 2 452 979**
**DE - B - 1 164 819**
**DE - C - 760 847**
**GB - A - 428 087**

(73) Patentinhaber: **HOECHST AKTIENGESELLSCHAFT,**
**Postfach 80 03 20, D-6230 Frankfurt am Main 80 (DE)**

(72) Erfinder: **Schön, Klaus-Peter, Rathenauplatz 14,**
**D-6200 Wiesbaden (DE)**
Erfinder: **Schmitt, Klaus, Buschungstrasse 54,**
**D-6200 Wiesbaden (DE)**

## Beschreibung

Die Erfindung betrifft eine Vorlagenhalterung für ein Druckplattenverarbeitungsgerät, mit einem Saugrahmen, einer an diesem schwenkbar gelagerten und daran abdichtend anlegbaren Glasabdeckung und einem Gasdruckelement, das die Glasabdeckung gegen einen Träger des Saugrahmens abstützt, und mit einer Vakuumleitung zu einer Vakuumpumpe zur Erzeugung des Saugrahmen-Unterdrucks.

Eine derarartige Vorlagenhalterung als Bestandteil eines Druckplattenverarbeitungsgeräts ist aus der DE-AS 2 452 979 bekannt. Bekannte Druckplattenverarbeitungsgeräte umfassen eine Aufladungsstation zum Aufladen der Druckplatten vor dem Belichten, eine Belichtungsvorrichtung zum Ausleuchten der Vorlage und eine optische Abbildungseinrichtung zum Abbilden der Vorlage auf die elektrostatisch aufgeladene Druckplatte sowie eine Transport-, Entwicklungs- und Trockeneinrichtung.

Mit Hilfe der Belichtungseinrichtung und der Abbildungseinrichtung wird eine Ganzseitenbelichtung durchgeführt und die Vorlage auf die elektrostatisch aufgeladene Druckplatte projiziert. Dabei müssen die Vorlage und die Druckplatte so positioniert sein, daß sie, um den gewünschten Abbildungsmaßstab zu erhalten, in der Objekt- bzw. Bildebene angeordnet sind. Dies geschieht für die Vorlage in der Weise, daß sie manuell auf einen horizontal ausgerichteten Saugrahmen einer Vorlagenhalterung aufgelegt, durch eine Glasplatte abgedeckt und anschließend der Saugrahmen um 90°C in die vertikale Belichtungsposition verschwenkt wird. Nach erfolgter Belichtung wird die Vorlagenhalterung wieder in die Horizontale geschwenkt, die Glasplatte geöffnet und die darin befindliche Vorlage gegen eine neue Vorlage ausgewechselt. Nach dem Schließen der Glasplatte wird die Vorlagenhalterung wieder in die senkrechte Belichtungsposition geschwenkt. Während dieser Arbeitsvorgänge ist das Druckplattenverarbeitungsgerät nicht in Betrieb, so daß seine Kapazitätsauslastung gering ist.

Aufgabe der Erfindung ist es, eine Vorlagenhalterung mit den im Oberbegriff des Anspruches 1 angeführten Merkmalen in bezug auf ihre Verarbeitungskapazität so zu verbessern, daß während der Belichtung einer ersten Vorlage die Vorbereitungen zum Belichten einer zweiten Vorlage in der Weise ausgeführt werden können, daß die zweite Vorlage in die Belichtungsposition ohne Entnahme der ersten Vorlage aus der Vorlagenhalterung gebracht werden kann.

Diese Aufgabe wird erfindungsgemäß durch eine Vorlagenhalterung nach den Merkmalen des Patentanspruchs 1 gelöst.

Die weitere vorteilhafte Ausgestaltung der Vorlagenhalterung ergibt sich aus den übrigen Patentansprüchen.

Durch die Erfindung wird die Verarbeitungskapazität eines Druckplattenverarbeitungsgeräts nahezu verdoppelt, da während des Belichtens der Vorlage auf dem ersten Saugrahmen der zweite Saugrahmen um 90° gegenüber dem ersten Saugrahmen geschwenkt, mit einer neuen Vorlage belegt und dem ersten Saugrahmen beigeklappt wird, so daß nach Beendigung des Belichtungsvorganges die zweite Vorlage nur noch in die Belichtungsposition gedreht und in die Öffnung der Belichtungseinrichtung geschoben werden muß.

Die Erfindung wird im folgenden anhand zweier zeichnerisch dargestellter Ausführungsbeispiele näher erläutert. Es zeigt

Fig. 1 eine Ansicht eines Geräteausschnitts einer bekannten Druckplattenverarbeitungsanlage,

Fig. 2 eine perspektivische Ansicht des Vorlagenhalters der Druckplattenverarbeitungsanlage nach Fig. 1,

Fig. 3 eine schematische Ansicht einer Vorlagenhalterung nach der Erfindung,

Fig. 3a ein Detail der Vorlagenhalterung nach Fig. 3 in einer Seitenansicht im Schnitt,

Fig. 4 eine schematische Ansicht der Vorlagenhalterung im zusammengeklappten, vertikalen Zustand der beiden Saugrahmen und im Abstand von der Öffnung der Belichtungseinrichtung entfernt, und

Fig. 5 eine schematische Ansicht, ähnlich derjenigen nach Fig. 4, einer weiteren Ausführungsform der Vorlagenhalterung nach der Erfindung.

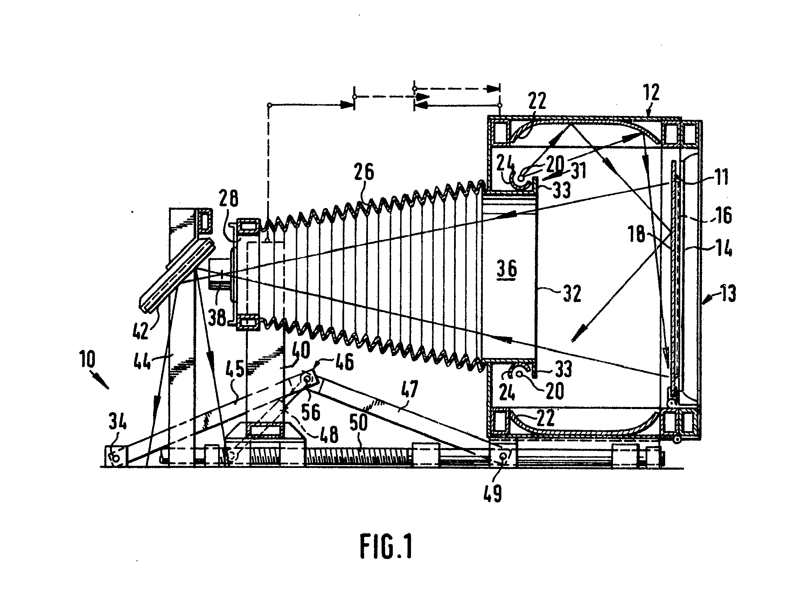

Der in Fig. 1 dargestellte Geräteausschnitt 10 eines bekannten Druckplattenverarbeitungsgerätes zeigt eine Belichtungseinrichtung 12 und eine Abbildungseinrichtung, bestehend aus einer Optik 38 mit Blende und einem Verschluß 28 sowie einem Spiegel 42, die mittels eines Kniehebelantriebs 46 verfahren werden, der aus zwei Hebeln 45, 47 besteht. Der erste Hebel 45 stützt sich in einem Festlager 34 ab, während der zweite Hebel 47 an einem Drehlager 49 an der Rückseite der Belichtungseinrichtung 12 angelenkt ist. Die beiden Hebel 45, 47 des Kniehebelantriebs 46 bilden zusammen mit der Spindel 50 ein bewegliches Dreieck. Im Anlenkpunkt 56 der beiden Hebel 45 und 47 greift ein weiterer Hebel 48 an. Ein nicht dargestellter Motor treibt die Spindel 50 an. Wird die Konsole 40 aufgrund der Spindeldrehung nach rechts in Richtung auf die Belichtungseinrichtung 12 verfahren, so bewegt sich gleichzeitig die Belichtungseinrichtung 12 auf die Konsole 40 zu. Sobald der Hebel 48 die Vertikalstellung durchlaufen hat, erfolgt eine Umkehr der Bewegungsrichtung der Belichtungseinrichtung 12, die dann ebenso wie die Konsole 40 in die gleiche Richtung nach rechts verfahren wird.

Eine Verkleinerung bzw. eine Vergrößerung der auf die Druckplatte projizierten Vorlage 16 wird durch entsprechendes Verfahren der Konsole 40 erzielt.

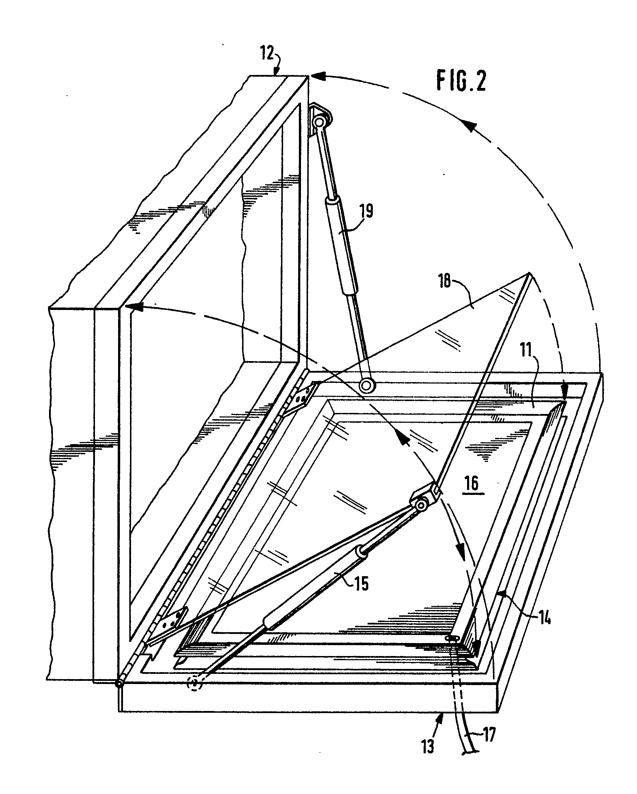

In der Rückseite einer Klapptür 13 der Belichtungseinrichtung 12 ist ein Vorlagenhalter 14 für die Aufnahme des Originals angeordnet. Wie aus Fig. 2 ersichtlich ist, ist der Vorlagenhalter 14 über eine Vakuumleitung 17 an eine nicht dargestellte Vakuumpumpe angeschlossen. Zum glatten Anpressen der Vorlage 16 an die Fläche des Vorlagenhalters 14 ist eine Glasplatte 18 vorgesehen, die auf einer umlaufenden Abdichtung 11 aufliegt. Ein Gasdruckelement 15, beispielsweise ein Gasdruckdämpfer, stützt die geöffnete Glasplatte 18 gegen die Klapptür 13 ab und sorgt dafür, daß die geöffnete Glasplatte 18 in ihrer jeweiligen Stellung verharrt, so daß ohne Behinderung die Vorlage 16 in den Vorlagenhalter 14 eingelegt werden kann. Die Klapptür 13 steht über ein weiteres Gasdruckelement 19 mit dem Gehäuse der Belichtungseinrichtung 12 in Verbindung, wobei dieses Gasdruckelement 19 die von Hand ausgeführte Schließ- bzw. Öffnungsbewegung der Klapptür 13 unterstützt.

Im Inneren der Belichtungseinrichtung 12 sind nahe der Rückseite Belichtungsquellen 20 zum Ausleuchten der Vorlage 16 angeordnet. Die Belichtungsquellen 20 sind von Reflektoren 24 umgeben, welche die einfallende Strahlung in Richtung weiterer Reflektoren 22 lenken, von denen aus die einfallende Strahlung unter einem bestimmten Winkel auf die in dem Vorlagenhalter 14 festgehaltene Vorlage 16 reflektiert wird. Eine Abdeckung 32 schirmt die Belichtungsquellen 20 gegenüber der Vorlage 16 ab und besteht aus einem an der Rückseite der Belichtungseinrichtung 12 die Eintrittsöffnung 36 eines Kamerabalgs 26 umschließenden Aufsatz 31. Der Aufsatz 31 weist eine Umrandung 33 auf. Der Kamerabalg 26 schließt an dem der Eintrittsöffnung 36 gegenüberliegenden Ende mit der über den Verschluß 28 betätigbaren Optik 38 ab. Der Balg 26 mit der Blende und der Optik 38 ist mit der ersten Konsole 40 verbunden. Der Spiegel 42 zum Umlenken der Lichtstrahlen, die von der beleuchteten Vorlage 16 durch den Balg 26, die Blende und die Optik 38 auf die Spiegeloberfläche auftreffen, ist im oberen Teil einer zweiten feststehenden Konsole 44 in Höhe der Optik 38 angeordnet. Der Spiegel 42 ist gegenüber der Horizontalen um einen Winkel, beispielsweise von 45°, geneigt.

Zum Einlegen der Vorlage 16 in den Vorlagenhalter 14 wird die Klapptür 13 der Belichtungseinrichtung 12 geöffnet, die Glasplatte 18 angehoben, die durch das Gasdruckelement 15 in ihrer Lage verbleibt, und die Vorlage 16 in den Vorlagenhalter 14 eingelegt. Danach wird die Klapptür 13 geschlossen und der Belichtungsvorgang der Vorlage 16 beginnt. Erst wenn dieser Belichtungsvorgang beendet ist, kann die Klapptür geöffnet, die Vorlage entnommen und eine neue Vorlage eingelegt werden, die durch Schließen der Klapptür in ihre vertikale Belichtungsposition gebracht wird.

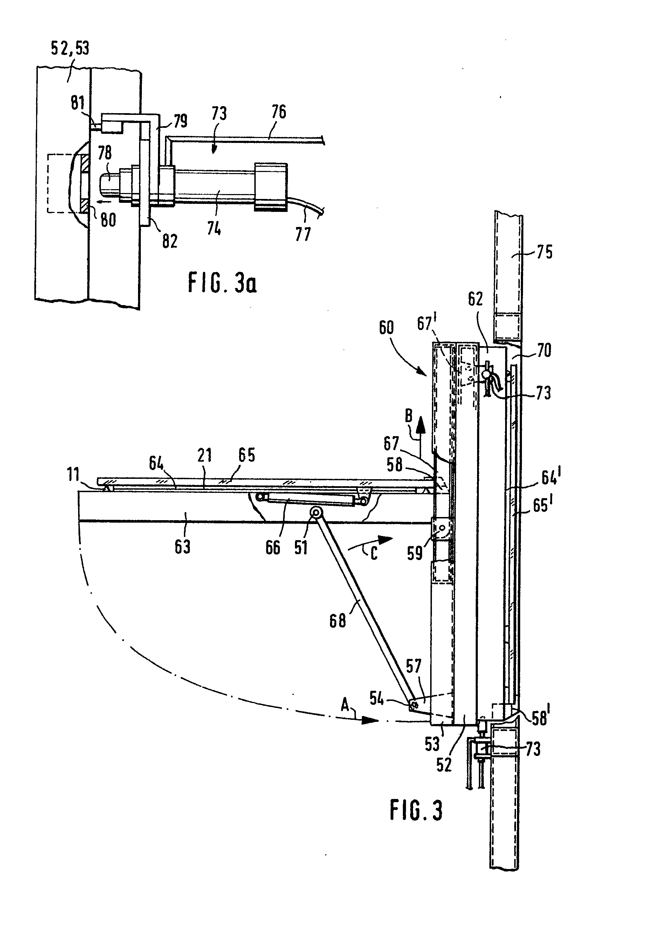

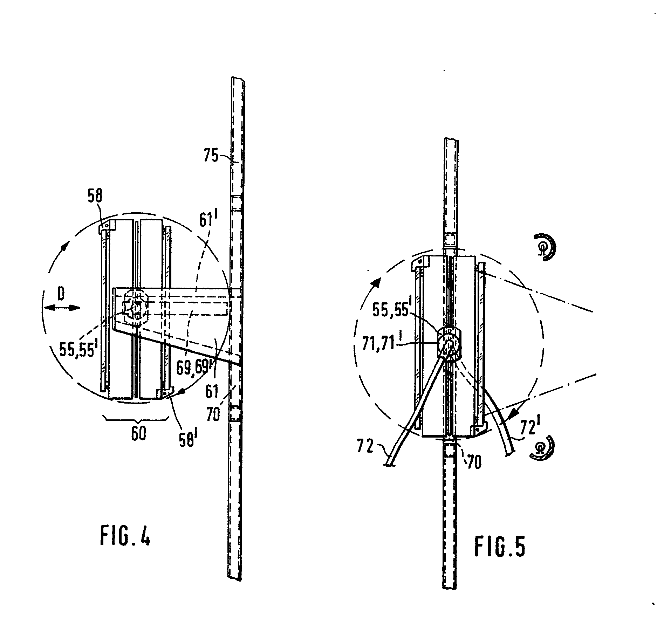

Fig. 3 zeigt eine Vorlagenhalterung 60 nach der Erfindung, die aus zwei Saugrahmen 62, 63 besteht, die horizontal verschiebbar und verschwenkbar sind. Der eine Saugrahmen 62 befindet sich in der senkrechten Belichtungsposition, während der zweite Saugrahmen 63 um 90° dazu in die Horizontale verschwenkt ist. Die Vorlagenhalterung 60 ist bei der in Fig. 4 schematisch dargestellten Ausführungsform der Erfindung mittels horizontaler Stütz- und Führungsarme 61, 61' an der Außenseite einer Gehäusewand 75 der Belichtungseinrichtung 12 befestigt. Die Belichtungseinrichtung 12 ist beispielsweise die in Fig. 1 gezeigte, an sich bekannte Belichtungseinrichtung und wird daher nicht mehr dargestellt.

In der senkrechten Belichtungsposition verschließt der Saugrahmen 62 eine Belichtungsöffnung 70 der Belichtungseinrichtung 12. Die Saugrahmen 62, 63 sind in Trägern 52, 53 verschiebbar angeordnet, und an jedem Träger sind seitliche Drehgelenke 55, 55' (vgl. Fig. 4 und 5) befestigt, die ein Verschwenken der Vorlagenhalterung 60 um 360° ermöglichen.

Die Träger 52, 53 bestehen aus U-Profil-Blechen; diese weisen die beiden Führungsbahnen 67 und 67' auf, bei denen es sich beispielsweise um Kugelschienenführungen handelt. In den beiden linearen Führungsbahnen eines Trägers ist der zugehörige Saugrahmen verschiebbar. Die Führungsbahnen 69, 69' der horizontalen Stütz- und Führungsarme 61, 61' nehmen die Drehgelenke 55, 55' der Träger 52, 53 auf. In der sogenannten zusammengeklappten Lage der Vorlagenhalterung 60 sind die Rückseiten der Träger einander zugewandt und die Glasplatten 65, 65' der beiden Saugrahmen 62, 63 weisen in dieser Lage nach außen. In der zusammengeklappten Lage ist die Vorlagenhalterung 60 entlang der Führungsbahnen 69, 69' in den Stütz- und Führungsarmen 61, 61' in die senkrechte Belichtungsposition verschiebbar bzw. aus dieser Position herausziehbar.

Wie aus Fig. 3 zu ersehen, ist ein Hebel 68 mit einem Ende an dem Saugrahmen 63 in einem Anlenkpunkt 51 und mit dem anderen Ende an einem Stützlager 57 im Anlenkpunkt 54 befestigt. Das Stützlager 57 is an dem Träger 53 angebracht. Der Hebel ist um die Anlenkpunkte 51, 54 schwenkbar und bildet zusammen mit der Kugelschienenführung 67 bzw. 67' in dem Träger 52 bzw. 53 ein Hebelgetriebe. Wird der in Fig. 3 horizontale Saugrahmen 63 nach unten in Richtung des Pfeils A geschwenkt, beschreibt der Hebel 68 eine kreisbogenförmige Bewegung in Richtung C auf den Träger 53 zu, während ein in der Kugelschienenführung 67 des Trägers 53 aufgenommenes Gleitlager 59 des Saugrahmens 63 nach oben in Richtung des Pfeils B verschoben wird. Auf diese Weise wird der Saugrahmen 63 in die senkrechte Position geklappt und liegt an seinem zugehörigen Träger 53 an.

Obwohl dies zeichnerisch nicht dargestellt ist, verbindet ein derartiger Hebel 68 in der gleichen Weise den Saugrahmen 62 über das Stützlager 57 mit dem zugehörigen Träger 52.

Der Träger 52 des die Belichtungsöffnung 70 der Belichtungseinrichtung 12 verschließenden Saugrahmens 62 wird durch drei Verriegelungseinrichtungen 73 während des Belichtens mit der Gehäusewand 75 verriegelt, so daß eine Veränderung seiner Position während der Belichtung nicht möglich ist.

Wie in Fig. 3a gezeigt, besteht eine Verriegelungseinrichtung 73 aus einem Pneumatikzylinder 74, der über Leitungen 76, 77 an eine nicht dargestellte Druckquelle angeschlossen ist. Der Pneumatikzylinder 74 ist über eine Platte 82 mit dem Gehäuse des Druckplattenverarbeitungsgeräts verbunden und sein Kolben trägt einen Verriegelungsstift 78, der in ein Loch einer Fahne 80, die am Träger 52 bzw. 53 befestigt ist, eingreift und dadurch den Träger mit dem Gehäuse in der senkrechten Position verriegelt. An einem Bügel 79 ist ein Mikroschalter 81 angebracht, der durch den hochgeschwenkten Träger geschaltet wird und die Druckbeaufschlagung des Pneumatikzylinders 74 einleitet und damit die Verriegelung herbeiführt. Es sind beispielsweise drei Verriegelungseinrichtungen 73 vorgesehen, je eine an jeder senkrechten Kante der Gehäusewand, in Fig. 3 in der oberen Position dargestellt und eine Verriegelungseinrichtung 73 in der Mitte der unteren Querkante der Belichtungsöffnung 70, so daß eine Dreipunktverriegelung erfolgen kann.

Die Saugrahmen 62 und 63 sind identisch aufgebaut und nehmen jeweils eine Vorlage 64 bzw. 64' auf einer Mattglasscheibe 21 auf, die durch die Glasplatten 65 bzw. 65' abgedeckt werden, die auf einer Abdichtung 11 aufliegen. Ein Gasdruckelement bzw. Gasdruckdämpfer 66, ähnlich dem Gasdruckelement 15 in Fig. 2, verbindet die Glasplatte 65 bzw. 65' mit dem Saugrahmen 63 bzw. 62 und hält die Glasplatte 65 bzw. 65', die um ein Scharnier 58 bzw. 58' schwenkbar ist, in ihrer jeweiligen Öffnungsstellung fest.

Bei der in den Fig. 3 und 4 gezeigten Ausführungsform der Erfindung ist die Vorlagenhalterung 60 in den seitlichen horizontal verlaufenden Stütz- und Führungsarmen 61, 61' verschiebbar angeordnet, wobei diese Stütz- und Führungsarme an der Gehäusewand 75 der Belichtungseinrichtung 12 befestigt sind. Das Verschwenken der in Fig. 4 zusammengeklappt gezeigten Vorlagenhalterung 60 um die Drehgelenke 55, 55', die Einrasterpunkte aufweisen, in denen die Vorlagenhalterung beim Verschwenken einrastet und somit positionierbar ist, erfolgt außerhalb der Belichtungseinrichtung 12.

In Fig. 5 ist schematisch eine Vorlagenhalterung 60 dargestellt, bei der Drehgelenke 55, 55' an der Umrandung der Belichtungsöffnung 70 der Belichtungseinrichtung 12 ortsfest befestigt sind. Dadurch ist ein Schwenken der Vorlagenhalterung 60 innerhalb der Belichtungseinrichtung 12 möglich, wobei während des Verschwenkens um die Drehgelenke 55, 55' der Vorlagenhalterung um beispielsweise 180° diese eine Bewegungsbahn im Inneren der Belichtungseinrichtung 12 durchläuft. Vakuumleitungen 72, 72' zu den Saugrahmen 62 bzw. 63 zum Evakuieren der Vorlagenhalterung 60 sind durch Bolzen 71, 71' der Drehgelenke 55, 55' hindurchgeführt.

In Fig. 3 sind die seitlichen Stütz- und Führungsarme 61, 61' zur besseren Übersichtlichkeit weggelassen.

Ausgehend von der in Fig. 4 gezeigten Stellung der Vorlagenhalterung 60, die in Richtung des Doppelpfeiles D hin- und herschiebbar ist, läuft das Einlegen der Vorlage 64 in den Saugrahmen 63 wie folgt ab. Der Saugrahmen 63 wird in die Horizontale verschwenkt (Fig. 3), die Glasplatte 65 wird mit Unterstützung des Gasdruckelements 66 hochgeklappt, das ähnlich wie eine Gasdruckfeder das Zurückfallen der Glasplatte in ihre Ausgangslage abdämpft und die Glasplatte in geöffneter Stellung hält. In dieser kann die Vorlage 64 ohne Schwierigkeiten eingelegt werden. Danach wird die Glasplatte geschlossen, der Saugrahmen 63 evakuiert, an seinen Träger 53 in eine senkrechte Belichtungsposition herangeklappt und die gesamte Vorlagenhalterung 60 um 180° verschwenkt, so daß die Vorlage 64 gegen die Belichtungsöffnung 70 gerichtet ist. Als nächster Schritt wird die Vorlagenhalterung 60 in Richtung auf die Belichtungseinrichtung 12 verfahren und der Saugrahmen 63 verschließt die Belichtungsöffnung 70 und wird über die Verriegelungseinrichtung 73 mit der Gehäusewand 75 verriegelt. Zugleich mit dem Aktivieren der Verriegelungseinrichtung 73 wird die Stromversorgung zum Belichten der Vorlage 64 eingeschaltet.

Während sich der eine Saugrahmen 63 in der senkrechten Belichtungsposition befindet, wird der zweite Saugrahmen 62 über seine Führungsbahn 67' mittels des Hebels 68 um 90° in die Horizontale geschwenkt, die Vorlage 64' eingelegt und danach wieder senkrecht an seinen Träger 52 beigeklappt. Nach dem Belichtungsvorgang der Vorlage 64 wird die gesamte Vorlagenhalterung 60 von der Belichtungsöffnung 70 weggezogen und in einer Wechselstellung um 180° gedreht und für den nächsten Belichtungsvorgang wieder beigeschoben, so daß nunmehr der Saugrahmen 62 mit der Vorlage 64' die Belichtungsöffnung 70 verschließt.

Da der Vorlagenwechsel während des Belichtungsvorganges einer ersten Vorlage abläuft, beeinflußt er in keiner Weise den zeitlichen Ablauf in der Belichtungseinrichtung 12 und somit auch nicht die Taktzeit des Druckplattenverarbeitungsgeräts, wodurch dessen Verarbeitungskapazität im Vergleich zu bekannten Geräten erheblich gesteigert wird.

## Patentansprüche

1. Vorlagenhalterung für ein Druckplattenverarbeitungsgerät, mit einem Saugrahmen einer an diesem schwenkbar gelagerten und daran abdichtend anlegbaren Glasabdeckung und einem Gasdruckelement, das die Glasabdeckung gegen einen Träger des Saugrahmens abstützt, und mit einer Vakuumleitung zu einer Vakuumpumpe, zur Erzeugung des Saugrahmen-Unterdrucks, dadurch gekennzeichnet, daß die Vorlagenhalterung (60) zwei Saugrahmen (62, 63) umfaßt, die in je einem Träger (52, 53) durch Verschieben und Verschwenken aus diesem herausklappbar gelagert sind, wobei die Träger (52, 53) mit ihren Rückseiten aneinanderliegen, und daß an den Trägern (52, 53) seitlich Drehgelenke (55, 55') befestigt sind, die ein gemeinsames Verschwenken der Träger (52, 53) um 360° ermöglichen.

2. Vorlagenhalterung nach Anspruch 1, dadurch gekennzeichnet, daß die Träger (52, 53) aus U-Profil-Blechen bestehen.

3. Vorlagenhalterung nach den Ansprüchen 1 und 2, dadurch gekennzeichnet, daß in jedem Träger (52, 53) für den zugehörigen Saugrahmen (62, 63) an parallelen Seiten je eine lineare Führungsbahn (67; 67') vorhanden ist.

4. Vorlagenhalterung nach Anspruch 1, dadurch gekennzeichnet, daß die Drehgelenke (55; 55') Einrastpunkte aufweisen, in denen die Vorlagenhalterung (60) beim Verschwenken positionierbar ist.

5. Vorlagenhalterung nach Anspruch 1, dadurch gekennzeichnet, daß seitlich der Träger (52, 53) horizontale Stütz- und Führungsarme (61, 61') mit horizontalen Führungsbahnen (69, 69') vorgesehen sind, welche die Drehgelenke (55, 55') der Träger (52, 53) aufnehmen, und daß die Träger (52, 53) entlang dieser Führungsbahnen in senkrechter Lage in die Belichtungsposition verschiebbar bzw. aus dieser herausziehbar sind.

6. Vorlagenhalterung nach Anspruch 1, dadurch gekennzeichnet, daß die Drehgelenke (55, 55') an der Umrandung der Belichtungsöffnung (70) der Belichtungseinrichtung (12) des Druckplattenverarbeitungsgeräts ortsfest befestigt sind und daß die Träger (52, 53) während des Verschwenkens um die Drehgelenke (55, 55') um 180° zur Hälfte eine Bewegungsbahn im Inneren der Belichtungseinrichtung (12) durchlaufen.

7. Vorlagenhalterung nach den Ansprüchen 3 und 5, dadurch gekennzeichnet, daß die Führungsbahnen (67, 67'; 69, 69') Kugelschienenführungen sind.

8. Vorlagenhalterung nach den Ansprüchen 1 bis 5 und 7, dadurch gekennzeichnet, daß je ein Hebel (68) mit einem Ende an einem Saugrahmen (62; 63) und mit dem anderen Ende über ein Stützlager (57) am zugehörigen Träger (52, 53) angelenkt ist.

9. Vorlagenhalterung nach Anspruch 8, dadurch gekennzeichnet, daß der Hebel (68) zusammen mit der Kugelschienenführung (67 bzw. 67') in dem Träger (52 bzw. 53) ein Hebelgetriebe bildet.

10. Vorlagenhalterung nach Anspruch 1, dadurch gekennzeichnet, das Verriegelungseinrichtungen (73) vorhanden sind, die den in der senkrechten Belichtungsposition befindlichen Träger (52 bzw. 53) während des Belichtens mit der Gehäusewand (75) der Belichtungseinrichtung verriegeln.

11. Vorlagenhalterung nach Anspruch 1, dadurch gekennzeichnet, daß die Vakuumleitungen (72, 72') durch Bolzen (71, 71') in den Drehgelenken (55, 55') hindurch zu den Saugrahmen (62, 63) geführt sind.

## Claims

1. Original holder for a printing plate processing apparatus, comprising a vacuum frame, a glass cover plate which is pivotably fastened to the vacuum frame and can be tightly pressed against the latter and a gas pressure element supporting the glass cover plate against a support of the vacuum frame, and a vacuum pipeline leading to a vacuum pump for producing vacuum in the vacuum frame, characterized in that the original holder (60) comprises two vacuum frames (62, 63), which are supported in one support (52, 53) each, from which they can be tilted away by shifting and swivelling, whereby the back sides of the supports (52, 53) adjoin each other, and in that swivel joints (55, 55') are laterally fastened to the supports (52, 53), by means of which a joint pivoting of the supports (52, 53) through an angle of 360° is made possible.

2. Original holder as claimed in Claim 1, characterized in that the supports (52, 53) are U-shaped metal sheets.

3. Original holder as claimed in Claim 1 and 2, characterized in that on parallel sides one linear guide rail (67, 67') each is provided in each support (52, 53) for the respective vacuum frame (62, 63).

4. Original holder as claimed in Claim 1, characterized in that the swivel joints (55, 55') are provided with stops where the original holder (60) can be firmly positioned when being pivoted.

5. Original holder as claimed in Claim 1, characterized in that lateral of the supports (52, 53) horizontal support and guide arms (61, 61') with horizontal guide rails (69, 69') are provided, which receive the swivel joints (55, 55') of the supports (52, 53) and in that the supports (52, 53) can be pivoted in vertical position into the exposure position or be withdrawn from this position along these guide rails.

6. Original holder as claimed in Claim 1, characterized in that the stationary swivel joints (55, 55') are fastened to the edging of the exposure aperture (70) of the exposure device (12) of the printing plate processing apparatus and in that the supports (52, 53) move along a path of motion by half in the interior of the exposure device (12) when being pivoted through an angle of 180° about the swivel joints (55, 55').

7. Original holder as claimed in Claim 3 and 5, characterized in that the guide rails (67, 67'; 69, 69') are ball guidances.

8. Original holder as claimed in Claim 1 to 5 and 7, characterized in that one end of a lever (68) each is pivotally mounted to a vacuum frame (62, 63), whereas the other end of this lever is pivotally fastened to the respective support (52, 53), via a support bearing (57).

9. Original holder as claimed in Claim 8, characterized in that the lever (68) together with the ball guidance (67, respect. 67'), forms a lever gearing in the support (52, respect. 53).

10. Original holder as claimed in Claim 1, characterized in that locking mechanisms (73) are provided by which the support (52, respect. 53) located in the vertical exposure position is firmly connected to the housing wall (75) of the exposure device (12) during the exposure.

11. Original holder as claimed in Claim 1, characterized in that the vacuum pipelines (72, 72') are led to the vacuum frames (62, 63) through pins (71, 71') in the swivel joints (55, 55').

## Revendications

1. Porte-originaux pour un appareil de traitement de plaques d'impression, comprenant un châssis à dépression, un recouvrement en verre monté basculant sur celui-ci et pouvant s'y appuyer de manière étanche et un élément à pression de gaz qui appuie ce recouvrement en verre contre un support du châssis à dépression, et une tuyauterie de vide allant à une pompe à vide servant à la production de la dépression du châssis à dépression, caractérisé en ce que le porteoriginaux (60) comprend deux châssis à dépression (62, 63) qui sont montés dans un support pour chacun (52, 53) de manière rabattable hors de celui-ci par déplacement en translation et basculement, les supports (52, 53) se faisant face l'un l'autre par leurs côtés arrière, et en ce que sur les supports (52, 53) sont fixés latéralement des articulations de pivotement (55, 55') qui permettent un basculement d'ensemble des supports (52, 53) de 360°.

2. Porte-originaux selon la revendication 1, caractérisé en ce que les supports (52, 53) sont formés de tôles profilées en U.

3. Porte-originaux selon la revendications 1 et 2, caractérisé en ce qu'il est prévu, dans chaque support (52, 53), pour le châssis à dépression associé (62, 63), sur des côtes parallèles, une glissière rectiligne (67, 67').

4. Porte-originaux selon la revendication 1, caractérisé en ce que les articulations de pivotement (55, 55') comprennent des points de verrouillage dans lesquels le porte-originaux (60) peut être positionné par basculement.

5. Porte-originaux selon la revendication 1, caractérisé en ce que, latéralement aux supports (52, 53), des bras horizontaux d'appui et de guidage (61, 61') sont munis de glissières horizontales (69, 69') dans lesquelles sont logées les articulations de pivotement (55, 55') des supports (52, 53), et en ce que les supports (52, 53) sont déplaçables en translation, le long de ces glissières, jusqu'en position verticale dans la position d'exposition ou pouvant être écartés de celles-ci.

6. Porte-originaux selon la revendication 1, caractérisé en ce que les articulations de pivotement (55, 55') sont fixées à demeure sur l'encadrement de l'ouverture d'expositions (70) du dispositif d'exposition (12) de l'appareil de traitement de plaques d'impression et en ce que, pendant le basculement de 180° autour des articulations de pivotement (55, 55'), les supports (52, 53) décrivent pour moitié une trajectoire à l'intérieur du dispositif d'exposition (12).

7. Porte-originaux selon les revendications 3 et 5, caractérisé en ce que les glissières (67, 67'; 69, 69') sont des guidages à rails à billes.

8. Porte-originaux selon les revendications 1 à 5 et 7, caractérisé en ce que à chaque fois un levier (68) est articulé par une extrémité sur un châssis à dépression (62, 63) et par l'autre extrémité sur le support associé (52, 53), par l'intermédiaire d'un support d'appui (57).

9. Porte-originaux selon la revendication 8, caractérisé en ce que le levier (68) forme un mécanisme à levier dans le support (52 ou 53) en commun avec le guidage à rail à billes (67 ou 67').

10. Porte-originaux selon la revendication 1, caractérisé en ce qu'il est prévu des dispositifs de verrouillage (73) qui, pendant l'exposition, verouillent le support (52 ou 53) se trouvant dans la position verticale d'exposition, sur la paroi de boîtier (75) du dispositif d'exposition.

11. Porte-originaux selon la revendication 1, caractérisé en ce que les tuyauteries de vide (72, 72') passant à travers des axes (71, 71') situés dans les articulations de pivotement (55, 55') jusqu'aux châssis à dépression (62, 63).

FIG.1

FIG.2

52,53

81

79

73

76

78

80

82

74

77

**FIG. 3a**

75

62

60

67'

70

73

B

67

64'

64

21

65

58

65'

11

63

66

51

59

C

68

57

A

54

58'

53

52

73

**FIG. 3**

FIG.4

FIG.5